# EUROPEAN PATENT APPLICATION

(11) **EP 3 081 956 A1**
(43) Date of publication of application: **19.10.2016**
(21) Application number: 14870176.6
(22) Date of filing: 23.05.2014
(51) Int. Cl.: G01S 7/481, G01S 17/58, H01S 3/00

(54) **LASER RADAR DEVICE**

(30) Priority: 10.12.2013 JP 2013255110
(71) Applicant: Mitsubishi Electric Corporation, Chiyoda-ku Tokyo 100-8310 (JP)
(72) Inventor: SAKIMURA, Takeshi, Tokyo 100-8310 (JP); YANAGISAWA, Takayuki, Tokyo 100-8310 (JP); MIWA, Yoshichika, Tokyo 100-8310 (JP)
(74) Representative: Pfenning, Meinig & Partner mbB
(86) International application number: PCT/JP2014/063724
(87) International publication number: WO 2015/087564

(57) **Abstract**

Disclosed is a laser radar device including a plurality of CW laser light sources 1 that oscillate laser lights having different frequencies, a plurality of optical branching couplers 2 each of that branches a laser light oscillated, a plurality of optical modulators 3 each of that modulates a laser light after being branched, an optical combining coupler 4 that combines laser lights modulated by the optical modulators, an optical combining coupler 5 that combines other laser lights after being branched, a transmission and reception optical system 8 that emits a composite light outputted by the optical combining coupler 4, and receives lights scattered by a target, an optical combining coupler 10 that combines the scattered lights received and a composite light outputted by the optical combining coupler 5, an optical detector 11 that detects beat signals from a composite light outputted by the optical combining coupler 10, a signal processing unit 12 that extracts information about the target from the beat signals detected, and a diffraction grating 9 that is placed forward or backward with respect to the transmission and reception optical system 8, and emits a light incident thereupon toward a specific direction according to the angle and the frequency of the incident light.

## Description

### FIELD OF THE INVENTION

The present invention relates to a laser radar device that emits a laser light into the air, receives a scattered light of that laser light which is scattered by a target, and extracts information about the target from the scattered light.

### BACKGROUND OF THE INVENTION

As a conventional laser radar device, there has been provided a coherent laser radar device that pulses a transmission light by using, as an optical modulator, an acousto-optic (AO) element which is pulse-driven (for example, refer to nonpatent reference 1).

Further, in a coherent laser radar device in which optical fibers are used as transmission paths for transmission lights (laser lights), the peak powers of the transmission lights are limited by a nonlinear optical effect which occurs in optical fibers and which is called stimulated Brillouin scattering. To solve this problem, a method of performing a measurement with a high S/N ratio by increasing the transmission power by using a plurality of CW laser light sources having different frequencies has been invented (for example, refer to patent reference 1).

### RELATED ART DOCUMENT

### Nonpatent reference

Nonpatent reference 1: "Proceedings of 11th Coherent Laser Radar Conference", written by G. N. Pearson and J. Eacock work (Malvern, Worcestershire, UK, July 2001), pp. 144-146.

### PATENT REFERENCE

Patent reference 1: Japanese Unexamined Patent Application Publication No. 2004-219207

### SUMMARY OF THE INVENTION

### PROBLEMS TO BE SOLVED BY THE INVENTION

The conventional coherent laser radar devices disclosed in nonpatent reference 1 and patent reference 1 can simply perform measurements only on the sight line direction of a transmission and reception optical system used for transmission and reception of a laser light.

Therefore, when performing a measurement on a different sight line direction or performing a measurement on a wider range and determining a distribution by performing an arithmetic operation or the like, it is necessary to scan the laser light. Therefore, there is a case in which such a coherent laser radar device is used in combination with a scanner device which employs a reflecting mirror, a rotation wedge plate or the like on which an angle adjustment can be performed. Further, there is a case in which a plurality of laser radar devices are arranged in order to simultaneously perform measurements on many sight line directions.

A problem with the method using the scanner device is that the device is upsized and becomes complicated. Another problem with the scanner device that mechanically drives a reflecting mirror or a wedge plate to rotate it is that the life of the device is reduced and the reliability of the device degrades.

A further problem with the method of scanning a laser light is that because the measurement time per one sight line direction becomes short, the received signal strength is reduced, the measurable distance is reduced and the accuracy of the measurement degrades.

The present invention is made in order to solve the above-mentioned problems, and it is therefore an object of the present invention to provide a laser radar device that can simultaneously perform measurements on many sight line directions with a simple and low-cost configuration and without using a scanner device that mechanically drives a component.

### MEANS FOR SOLVING THE PROBLEM

According to the present invention, there is provided a laser radar device including: a plurality of reference light sources that oscillate laser lights having different frequencies; a plurality of optical branchers that are disposed while being respectively brought into correspondence with the reference light sources, and each of that branches a laser light oscillated by a corresponding one of the reference light sources; a plurality of optical modulators that are disposed while being respectively brought into correspondence with the optical branchers, and each of that modulates one laser light after being branched by a corresponding one of the optical branchers; a first optical combiner that combines laser lights modulated by the optical modulators and outputs a first composite light; a second optical combiner that combines other laser lights after being branched by the optical branchers and outputs a second composite light; a transmission and reception optical system that emits the first composite light outputted by the first optical combiner, and receives scattered lights of the first composite light which are scattered by a target; a third optical combiner that combines the scattered lights received by the transmission and reception optical system and the second composite light outputted by the second optical combiner, and outputs a third composite light; an optical detector that detects beat signals from the third composite light outputted by the third optical combiner; an information extractor that extracts information about the target from the beat signals detected by the optical detector; and a dispersing element that is placed forward or backward with respect to the transmission and reception optical system, and emits a light incident thereupon toward a specific direction according to an angle and a frequency of the incident light.

Further, according to the present invention, there is provided a laser radar device including: a reference light source that oscillates a laser light having a specific frequency and can vary the frequency; an optical brancher that branches the laser light oscillated by the reference light source; an optical modulator that modulates one laser light after being branched by the optical brancher; a transmission and reception optical system that emits the laser light modulated by the optical modulator and receives a scattered light of the laser light which is scattered by a target; a fourth optical combiner that combines the scattered light received by the transmission and reception optical system and another laser light after being branched by the optical brancher, and outputs a fourth composite light; an optical detector that detects a beat signal from the fourth composite light outputted by the fourth optical combiner; an information extractor that extracts information about the target from the beat signal detected by the optical detector; and a dispersing element that is placed forward or backward with respect to the transmission and reception optical system, and emits a light incident thereupon toward a specific direction according to an angle and a frequency of the incident light.

### ADVANTAGES OF THE INVENTION

Because the laser radar device according to the present invention is configured as above, the laser radar device can simultaneously perform measurements on many sight line directions with a simple and low-cost configuration and without using a scanner device that mechanically drives a component.

### BRIEF DESCRIPTION OF THE FIGURES

[Fig. 1] Fig. 1 is a diagram showing the configuration of a laser radar device according to Embodiment 1 of the present invention;
[Fig. 2] Fig. 2 is a diagram showing the configuration of a laser radar device according to Embodiment 2 of the present invention;
[Fig. 3] Fig. 3 is a diagram showing the configuration of a laser radar device according to Embodiment 3 of the present invention;
[Fig. 4] Fig. 4 is a diagram showing the configuration of a laser radar device according to Embodiment 4 of the present invention;
[Fig. 5] Fig. 5 is a diagram showing the configuration of a laser radar device according to Embodiment 5 of the present invention;
[Fig. 6] Fig. 6 is a diagram showing the configuration of a laser radar device according to Embodiment 6 of the present invention;
[Fig. 7] Fig. 7 is a diagram showing the configuration of a laser radar device according to Embodiment 7 of the present invention; [Fig. 8] Fig. 8 is a diagram showing another example of the configuration of the laser radar device according to Embodiment 7 of the present invention;
[Fig. 9] Fig. 9 is a diagram showing another example of the configuration of the laser radar device according to Embodiment 7 of the present invention;
[Fig. 10] Fig. 10 is a diagram showing the configuration of a laser radar device according to Embodiment 8 of the present invention; and
[Fig. 11] Fig. 11 is a diagram showing another example of the configuration of the laser radar device according to Embodiment 8 of the present invention.

### EMBODIMENTS OF THE INVENTION

Hereafter, the preferred embodiments of the present invention will be explained in detail with reference to the drawings. The same components or like components in each embodiment are designated by the same reference character strings, and duplicated explanations will be omitted hereafter. Embodiment 1.

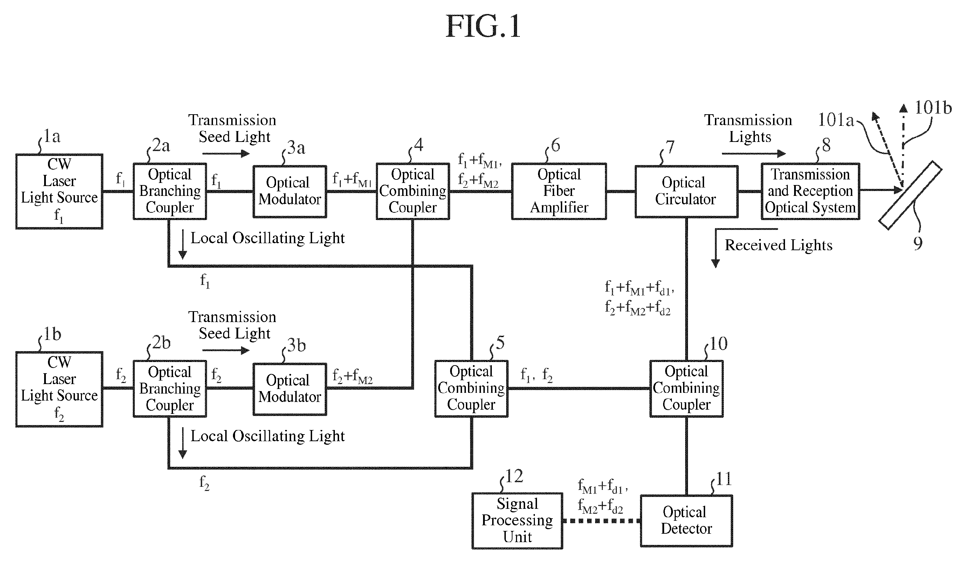

Fig. 1 is a diagram showing the configuration of a laser radar device according to Embodiment 1 of the present invention.

The laser radar device is a coherent Doppler lidar device that measures wind speeds by radiating a laser light into the air, receiving a scattered light from aerosols (particles such as dust suspended in the air), and detecting the Doppler shift of this scattered light. This laser radar device is comprised of a plurality of CW laser light sources (reference light sources) 1, a plurality of optical branching couplers 2, a plurality of optical modulators 3, an optical combining coupler (a first optical combiner) 4, an optical combining coupler (a second optical combiner) 5, an optical fiber amplifier 6, an optical circulator 7, a transmission and reception optical system 8, a diffraction grating (a dispersing element) 9, an optical combining coupler (a third optical combiner) 10, an optical detector 11 and a signal processing unit (an information extractor) 12, as shown in Fig. 1. The light propagation paths of laser lights within the device consist of optical fibers. Further, in Fig. 1, a case in which the laser radar device has two CW laser light sources 1a and 1b, two optical branching couplers 2a and 2b, and two optical modulators 3a and 3b is shown.

The CW laser light source 1a oscillates a CW (Continuous Wave) laser light having a specific frequency. The CW laser light oscillated by this CW laser light source 1a is coupled to an optical fiber and is outputted to the optical branching coupler 2a.

The CW laser light source 1b oscillates a CW laser light having a specific frequency. The CW laser light oscillated by this CW laser light source 1b is coupled to an optical fiber and is outputted to the optical branching coupler 2b.

The frequencies of the CW laser lights oscillated by the CW laser light sources 1a and 1b differ from each other, and fall within the gain band of the optical fiber amplifier 6. Further, the difference between the frequencies is set in such a way as to become larger than the gain bandwidth of stimulated Brillouin scattering occurring in the optical fiber.

Further, it is preferable that the spectral width of each CW laser light is as narrow as possible in order to improve the accuracy of coherent detection. For example, it is preferable to use CW laser lights each having a spectral width of 100 kHz or less. As the CW laser light sources 1a and 1b having this feature, for example, DFB (Distributed Feed-Back) fiber lasers, DFB-LDs (Laser Diodes), or the likes can be used.

The optical branching coupler 2a is disposed while being brought into correspondence with the CW laser light source 1a, and braches the CW laser light from the CW laser light source 1a into two CW laser lights. One of the two CW laser lights after being branched by this optical branching coupler 2a is outputted to the optical modulator 3a as a transmission seed light, while the other CW laser light is outputted to the optical combining coupler 5 as a local oscillating light for coherent detection.

The optical branching coupler 2b is disposed while being brought into correspondence with the CW laser light source 1b, and braches the CW laser light from the CW laser light source 1b into two CW laser lights. One of the two CW laser lights after being branched by this optical branching coupler 2b is outputted to the optical modulator 3b as a transmission seed light, while the other CW laser light is outputted to the optical combining coupler 5 as a local oscillating light for coherent detection.

It is preferable that the branching ratio of the light power in each of the optical branching couplers 2a and 2b has a small dependence on the frequency of the CW laser light.

The optical modulator 3a is disposed while being brought into correspondence with the optical branching coupler 2a, and pulses the transmission seed light from the optical branching coupler 2a and provides a frequency modulation (provides an intermediate frequency at the time of performing coherent detection) for the transmission seed light. The transmission seed light modulated by this optical modulator 3a is outputted to the optical combining coupler 4.

The optical modulator 3b is disposed while being brought into correspondence with the optical branching coupler 2b, and pulses the transmission seed light from the optical branching coupler 2b and provides a frequency modulation (provides an intermediate frequency at the time of performing coherent detection) for the transmission seed light. The transmission seed light modulated by this optical modulator 3b is outputted to the optical combining coupler 4.

The intermediate frequencies provided by the optical modulators 3a and 3b are set to different values, and the frequencies after the modulation performed by the optical modulators 3a and 3b are set to different values.

Further, by using, for example, acousto-optic modulators (AOMs) as the optical modulators 3a and 3b, the pulsing using the extraction of the CW laser light during each time gate and the provision of a frequency shift can be carried out simultaneously.

Further, each of the intermediate frequencies is typically about several tens of MHz to several hundreds of MHz, and values suitable for the system are selected as the intermediate frequencies.

The optical combining coupler 4 combines the transmission seed light modulated by the optical modulator 3a and the transmission seed light modulated by the optical modulator 3b. The transmission seed lights (a first composite light) which are combined by this optical combining coupler 4 are outputted to the optical fiber amplifier 6.

The optical combining coupler 5 combines the local oscillating light from the optical branching coupler 2a and the local oscillating light from the optical branching coupler 2b. The local oscillating lights (a second composite light) which are combined by this optical combining coupler 5 are outputted to the optical combining coupler 10.

At least one optical fiber amplifier 6 is disposed on a light propagation path on a transmit side, and amplifies the light power of the first composite light from the optical combining coupler 4. The first composite light whose light power is amplified by this optical fiber amplifier 6 is outputted to the optical circulator 7.

An amplifier corresponding to the wavelength band of the laser light to be used is used as each optical fiber amplifier 6. For example, when the wavelength of the laser light falls within a 1µm band, an optical fiber amplifier which employs an Nd (Neodymium) -doped fiber or an Yb (Ytterbium) -doped fiber can be used. Further, when the wavelength of the laser light falls within a 1. 55 µm band, an optical fiber amplifier which employs an Er (Erbium) -doped fiber can be used. In any of these optical fiber amplifiers, laser lights having a plurality of wavelengths can be amplified simultaneously when the optical fiber amplifier has a gain bandwidth of about several nm to several tens of nm and the laser light wavelengths fall within the gain band.

The optical circulator 7 selects its output destination according to the light incident thereupon. When the first composite light is inputted from the optical fiber amplifier 6, the optical circulator 7 outputs those transmission seed lights to the transmission and reception optical system 8. In contrast, when scattered lights are inputted from the transmission and reception optical system 8, the optical circulator outputs those scattered lights to the optical combining coupler 10.

The transmission and reception optical system 8 emits the first composite light which has passed through the optical circulator 7, as a transmission light, toward a target (an aerosol) via the diffraction grating 9, and receives scattered lights of those transmission lights, which are scattered by the target, via the diffraction grating 9. The scattered lights received by this transmission and reception optical system 8 are coupled to an optical fiber, and are outputted to the optical circulator 7.

As the transmission and reception optical system 8, a telescope or the like which can form each laser light to be emitted into an approximately collimated light and whose focal distance can be adjusted can be used. Although a fiber collimator or the like can be alternatively used as the transmission and reception optical system 8, it is preferable that the fiber collimator is configured so as to reduce the angle of divergence of each laser light to be emitted, and further has a large aperture in order to improve the reception efficiency.

The diffraction grating 9 is an optical element that diffracts each laser light incident thereupon to emit that laser light toward a specific direction according to the angle and the frequency of the laser light. The transmission light from the transmission and reception optical system 8 is the one into which the transmission seed lights having different frequencies are combined, and the lights diffracted by the diffraction grating 9 are emitted at different angles (toward the directions of transmission lights 101a and 101b) respectively. Because the aerosol is moving according to the flow (the wind) of the air, each scattered light receives a Doppler shift.

The optical combining coupler 10 combines the scattered lights from the optical circulator 7 and the second composite light from the optical combining coupler 5. A composite light (a third composite light) after being combined by this optical combining coupler 10 is outputted to the optical detector 11.

The optical detector 11 receives the third composite light from the optical combining coupler 10, and detects beat signals of the scattered lights and the local oscillating lights. The beat signals detected by this optical detector 11 are outputted to the signal processing unit 12.

The signal processing unit 12 processes the beat signals from the optical detector 11, extracts information about the target (e.g., information including the received signal strength of each scattered light, the round trip time, the Doppler frequency, etc.), and calculates movement features of the target (e.g., the distance to the target and a speed distribution) from that extracted information about the target.

Next, the operation of the laser radar device which is configured as above will be explained.

In the operation of the laser radar device, first, the CW laser light source 1a oscillates a CW laser light having a specific frequency f1, and outputs this CW laser light to the optical branching coupler 2a. Further, the CW laser light source 1b oscillates a CW laser light having a specific frequency f2, and outputs this CW laser light to the optical branching coupler 2b.

It is assumed hereafter that the frequencies f1 and f2 of the CW laser lights oscillated by the CW laser light sources 1a and 1b differ from each other and fall within the gain band of the optical fiber amplifier 6, and the difference between the frequency f1 and the frequency f2 is larger than the gain bandwidth of stimulated Brillouin scattering occurring in the optical fiber.

The optical branching coupler 2a then braches the CW laser light having the frequency f1 from the CW laser light source 1a into two laser lights, and outputs one of these laser lights to the optical modulator 3a as a transmission seed light and outputs the other laser light to the optical combining coupler 5 as a local oscillating light for coherent detection. Further, the optical branching coupler 2b braches the CW laser light having the frequency f2 from the CW laser light source 1b into two laser lights, and outputs one of these laser lights to the optical modulator 3b as a transmission seed light and outputs the other laser light to the optical combining coupler 5 as a local oscillating light for coherent detection.

The optical modulator 3a then pulses the transmission seed light having the frequency f1 from the optical branching coupler 2a, and provides a frequency modulation (provides an intermediate frequency fM1 at the time of performing coherent detection) for the transmission seed light.

The transmission seed light having a frequency f1+fM1 which is modulated by this optical modulator 3a is outputted to the optical combining coupler 4. Further, the optical modulator 3b pulses the transmission seed light having the frequency f2 from the optical branching coupler 2b, and provides a frequency modulation (provides an intermediate frequency fM2 at the time of performing coherent detection) for the transmission seed light. The transmission seed light having a frequency f2+fM2 which is modulated by this optical modulator 3b is outputted to the optical combining coupler 4.

In this embodiment, the intermediate frequencies fM1 and fM2 are set to different values, and are set in such a way that the following condition (fM1+fd1) < (fM2+fd2) or (fM1+fd1) > (fM2+fd2) is satisfied. As a result, the next-stage signal processing unit 12 can discriminate between the two frequency components (fM1+fd1, fM2+fd2) of the beat signals detected by the optical detector 11, and can measure the signal strength of each frequency component individually. As a result, because the Doppler shift amounts fd1 and fd2 corresponding to the frequencies of the transmission light can be measured respectively, wind speed distributions in sight line directions corresponding to the frequencies of the transmission light can be measured respectively.

Then, the optical combining coupler 4 combines the transmission seed light having the frequency f1+fM1 which is modulated by the optical modulator 3a and the transmission seed light having the frequency f2+fM2 which is modulated by the optical modulator 3b. The transmission seed lights (the first composite light having the frequencies f1+fM1 and f2+fM2) which are combined by this optical combining coupler 4 are outputted to the optical fiber amplifier 6.

Further, the optical combining coupler 5 combines the local oscillating light having the frequency f1 from the optical branching coupler 2a and the local oscillating light having the frequency f2 from the optical branching coupler 2b. The local oscillating lights (the second composite light having the frequencies f1 and f2) which are combined by this optical combining coupler 5 are outputted to the optical combining coupler 10.

The optical fiber amplifier 6 then amplifies the light power of the first composite light from the optical combining coupler 4. The first composite light whose light power is amplified by this optical fiber amplifier 6 is outputted to the optical circulator 7. By using this optical fiber amplifier 6, the light power of the laser light to be transmitted can be increased, the intensity of each received light can be increased, and the accuracy of measurements can be improved and the measurable distance can be increased.

Because stimulated Brillouin scattering occurs when a laser light whose light power is equal to or greater than a constant value is incident upon the optical fiber, the laser light power which can be inputted into the optical fiber is limited. It is known that a typical optical fiber has a gain bandwidth of about several tens of MHz to several hundreds of MHz for stimulated Brillouin scattering.

Therefore, when, for example, two laser lights having a frequency difference larger than 100 MHz (e.g., which corresponds to a wavelength difference of about 0.8 pm when the wavelength of one of the laser lights is 1,550 nm) are incident upon the optical fiber, the gains of stimulated Brillouin scattering for those two laser lights can be made to differ from each other. Therefore, those two laser lights can be inputted while each of their light powers is increased to an incident power which is a threshold for the occurrence of stimulated Brillouin scattering.

Further, the same goes for a case in which a plurality of laser lights are inputted, and by using a plurality of laser lights having frequency differences thereamong larger than the gain bandwidth of stimulated Brillouin scattering, their laser light powers which can be inputted into the optical fiber can be increased.

There is a case in which the power of one laser light exceeds the threshold for stimulated Brillouin scattering in the process of amplifying the light powers of the laser lights in the optical fiber amplifier 6. Because the peak power becomes large easily particularly when amplifying pulsed lights, stimulated Brillouin scattering easily occurs. Therefore, by adjusting the output light powers by, for example, usually limiting the excitation power supplied to the optical fiber amplifier 6 in such a way as to prevent stimulated Brillouin scattering from occurring, the optical fiber amplifier is used.

In this Embodiment 1, the difference between the frequencies f1 and f2 of the CW laser lights oscillated by the CW laser light sources 1a and 1b is larger than the gain bandwidth of stimulated Brillouin scattering occurring in the optical fiber, as mentioned above. Therefore, with respect to these laser lights, the peak powers of the output pulsed lights can be increased to their respective stimulated Brillouin scattering thresholds PSBS1 and PSBS2.

As a result, when the average output powers of the laser lights (each of the average output powers is expressed by the product of the peak power, the pulse width and the pulse repetition frequency of the pulsed light) are expressed by PS1 and PS2, the average power of the outputted light of the optical fiber amplifier 6 can be set to PS1+PS2 and the light power of the transmission light can be increased as compared with a case in which a single light source (for example, either the CW laser light source 1a or the CW laser light source 1b) is used. As a result, when PS1=PS2, the light power of the transmission light can be doubled by using the two CW laser light sources 1a and 1b.

Further, the input power increases in the optical fiber amplifier 6 by using the plurality of CW laser light sources 1a and 1b.Therefore, the efficiency of extraction of the energy can be improved, and the occurrence of an ASE (Amplified Spontaneous Emission) component at the time of amplification of the laser light can be reduced. Therefore, there are provided an effect of improving the efficiency of the optical fiber amplifier 6 and an effect of reducing noise components in the optical detector 11.

Then, the optical circulator 7 outputs the transmission seed lights from the optical fiber amplifier 6 to the transmission and reception optical system 8.

The transmission and reception optical system 8 then emits the transmission seed lights which have passed through the optical circulator 7, as the transmission light, toward the target via the diffraction grating 9. In the configuration shown in Fig. 1, the transmission light emitted from the transmission and reception optical system 8 is the one into which the laser light having the frequency f1+fM1 and the laser light having the frequency f2+fM2 are combined, and these laser lights differ from each other in frequency. Therefore, the lights diffracted by the diffraction grating 9 are emitted at different angles (in this case, it is assumed that the laser light having the frequency f1+fM1 incident upon the diffraction grating 9 propagates in the direction of the transmission light 101a, and the laser light having the frequency f1+fM2 incident upon the diffraction grating 9 propagates in the direction of the transmission light 101b). As a result, the laser lights can be emitted into the air and toward two different sight line directions.

Further, because the degree of angle of diffraction of each laser light by the diffraction grating 9 is determined by the structural parameters of the diffraction grating 9, and the wavelength (the frequency) and the angle of incidence of the laser light, each of the emission directions of the transmission lights 101a and 101b can be determined as long as these values are grasped.

Then, the transmission lights 101a and 101b emitted via the diffraction grating 9 by the transmission and reception optical system 8 are scattered by an aerosol existing in the air. When lights scattered by this aerosol are then incident upon the diffraction grating 9, the lights return to the transmission and reception optical system 8 reversibly, and the transmission and reception optical system 8 receives these scattered lights and outputs the lights to the optical circulator 7.

By using the diffraction grating 9 in the above-mentioned way, the propagation angles of the laser lights can be varied according to their frequencies, and the laser lights can be transmitted and received to and from the two different sight line directions.

Because the aerosol is moving according to the flow (the wind) of the air, each of the scattered lights receives a Doppler shift.

Therefore, when the Doppler shifts which the laser light having the frequency f1+fM1 and the laser light having the frequency f2+fM2, which are the transmission light, receive are expressed by fd1 and fd2, respectively, the frequencies of the scattered lights are f1+fM1+fd1 and f2+fM2+fd2, respectively.

Then, the optical circulator 7 outputs the scattered lights from the transmission and reception optical system 8 to the optical combining coupler 10.

The optical combining coupler 10 then combines the scattered lights from the optical circulator 7, and the second composite light having the frequencies f1 and f2 from the optical combining coupler 5. A composite light (a third composite light) after being combined by this optical combining coupler 10 is outputted to the optical detector 11.

Then, the optical detector 11 receives the third composite light from the optical combining coupler 10, and detects beat signals of the scattered lights and the local oscillating lights. The scattered lights included in the third composite light which is received by the optical detector 11 receive the frequency shifts provided by the optical modulators 3a and 3b and the Doppler shifts caused by the movement of the aerosol, respectively. Therefore, the frequencies of the beat signals detected by the optical detector 11 are fM1+fd1 and fM2+fd2. The beat signals detected by this optical detector 11 are outputted to the signal processing unit 12.

The signal processing unit 12 processes the beat signals from the optical detector 11, extracts information about the target (e.g., information including the received signal strength of each scattered light, the round trip time, the Doppler frequency, etc.), and calculates movement features of the target (e.g., the distance to the target and a speed distribution) from that extracted information about the target. Because the process of calculating the movement features of the target from the information about the target is a known technique, a detailed explanation of the process will be omitted hereafter.

In the laser radar device shown in Fig. 1, the intermediate frequencies fM1 and fM2 are set to different values, and are set in such a way that the following condition (fM1+fd1)<(fM2+fd2) or (fM1+fd1) > (fM2+fd2) is satisfied. Therefore, the next-stage signal processing unit 12 can discriminate between the two frequency components (fM1+fd1, fM2+fd2) of the beat signals detected by the optical detector 11, and can measure the signal of each frequency component individually. Because the intermediate frequencies fM1 and fM2 are known values provided by the optical modulators 3a and 3b, fd1 and fd2 can be determined by performing an arithmetic operation.

fd1 denotes the Doppler shift which the transmission light having the frequency f1+fM1 receives, and fd2 denotes the Doppler shift which the transmission light having the frequency f2+fM2 receives. Because those two transmission lights are emitted toward different directions by the diffraction grating 9, the Doppler shifts associated with the two different sight line directions can be measured simultaneously.

As mentioned above, because the laser radar device according to this Embodiment 1 is configured in such a way as to transmit and receive the laser lights based on the two CW laser light sources 1a and 1b by using the single transmission and reception optical system 8, perform observations on two different sight line directions by using the diffraction grating 9, and detect received signals by using the single optical detector 11, the configuration of the device can be simplified and downsizing and a cost reduction of the device can be achieved.

Further, because the laser radar device can perform measurements on two sight line directions without using a scanner device, the configuration of the device can be simplified and downsizing and a cost reduction of the device can be achieved. In addition, because no mechanical driving system is needed, the life of the device can be extended and the reliability of the device can be improved.

Further, because the laser radar device can measure wind speed distributions about two different sight line directions in the above-mentioned configuration, the laser radar device can also determine two-dimensional distributions of wind directions and wind speeds in a region including the two sight line directions by performing an approximate process and an arithmetic operation. In addition, because the laser radar device can simultaneously measure the wind speeds in the two different sight line directions in the above-mentioned configuration, the laser radar device can determine real-time two-dimensional distributions of wind directions and wind speeds. As a result, the laser radar device shown in Fig. 1 can be used to measurements of two-dimensional distributions of wind directions and wind speeds, and measurements of instant changes of wind direction and wind speed distributions.

Further, by matching the planes of polarization of the local oscillating lights to those of the scattered lights, which are the received lights, in the optical detector 11, efficient coherent detection can be carried out. The planes of polarization of the local oscillating lights can be matched to those of the scattered lights by using a plane-of-polarization controller or the like not shown in the figure.

In addition, in a case of using an optical fiber of plane-of-polarization preservation type as each optical fiber for coupling between optical elements and also using an optical fiber part of plane-of-polarization preservation type as each optical element, the planes of polarization of the local oscillating lights can be matched to those of the scattered lights even if a plane-of-polarization controller or the like is not used. As a result, the configuration of the device can be simplified.

By using optical fiber parts and also using optical fibers for the light propagation paths of the laser lights, as shown in the configuration of Fig. 1, the routing of the optical paths of the laser lights is facilitated, the device can be downsized, and the device can be configured easily via connections of the optical fibers. Further, because the alignment of optical axes is unnecessary, the stability of the device is improved and a reliable device configuration can be provided. In addition, because the need to make an adjustment to the planes of polarization is eliminated by using optical fibers of plane-of-polarization preservation type, and optical elements and optical fiber parts of plane-of-polarization preservation type, as mentioned above, the configuration of the device can be simplified and the device can be configured with a small size and high reliability.

Further, in the optical modulators 3a and 3b, the times when the laser lights are pulsed can be synchronized with each other by using a signal generator or the like not shown in the figure. As a result, because the rising times of the pulsed laser lights which are combined by the optical combining coupler 4 can be matched to each other and the emission times of the transmission lights having different frequencies can be matched to each other, processes in the signal processing unit 12, such as measurements of the round trip times of the transmission lights, can be simplified.

Further, although the two CW laser light sources 1a and 1b are used in the configuration shown in Fig. 1, a larger number of CW laser light sources 1 can be used. In this case, optical branching couplers 2 and optical modulators 3 whose numbers are equal to the number of additional CW laser light sources 1 are added, all the transmission seed lights are combined by the optical combining coupler 4, and all the transmission seed lights are combined by the optical combining coupler 5. Further, the frequencies of the CW laser light sources differ from one another and fall within the gain band of the optical fiber amplifier 6. Further, the differences among the frequencies are set in such a way as to become larger than the gain bandwidth (about 100 MHz) of stimulated Brillouin scattering occurring in the optical fiber. In addition, the intermediate frequency provided by each optical modulator 3 is set to be a value with which the signal processing unit 12 can identify the corresponding received signal individually.

As a result, because diffractions occur in the diffraction grating 9 according to the frequencies of laser lights, and the laser lights can be emitted toward directions whose number corresponds to the number of CW laser light sources 1, wind speeds in the sight line directions whose number corresponds to the number of laser light sources can be measured simultaneously. As a result, two-dimensional distributions of wind directions and wind speeds can be determined with a higher degree of accuracy.

Further, although the diffraction grating 9 shown in Fig. 1 has the configuration of a reflection type diffraction grating that reflects diffracted lights, a transmission type diffraction grating that allows laser lights to pass therethrough and causes diffractions can be alternatively used. Further, by using a diffraction grating that is designed in such a way that the diffraction efficiency increases with respect to the wavelength band of the laser lights is used as the diffraction grating 9, the loss of the laser lights on which transmission and reception are performed can be reduced and the efficiency of the device can be improved. In addition, high-order diffracted lights generated by the diffraction grating 9 can be blocked by using an aperture or the like not shown in the figure. Further, the diffraction grating 9 should just be a dispersing element that can vary the propagation angle of a laser light according to the wavelength of the laser light, and a prism can be used instead of the diffraction grating.

### Embodiment 2.

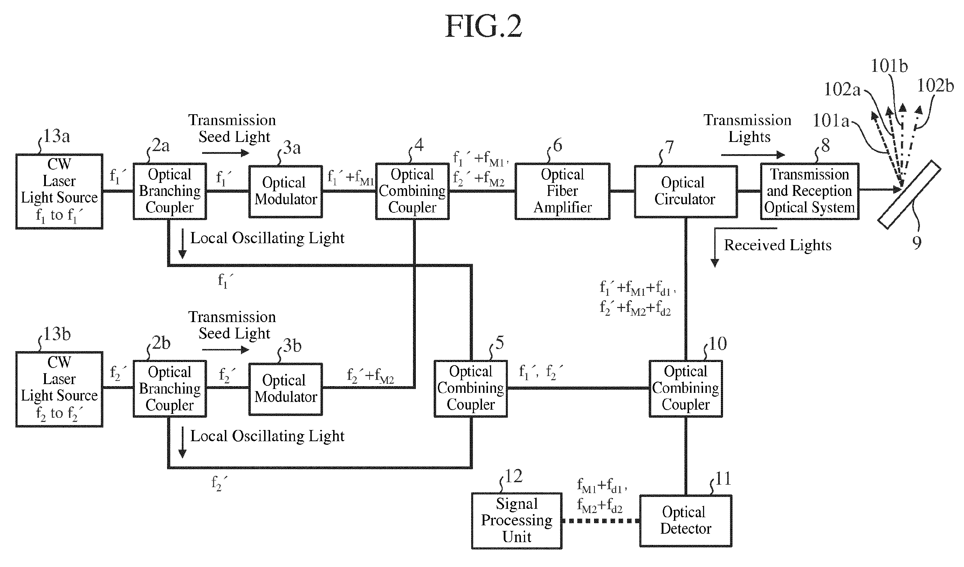

Fig. 2 is a diagram showing the configuration of a laser radar device according to Embodiment 2 of the present invention. The laser radar device according to Embodiment 2 shown in Fig. 2 is a one in which the CW laser light sources 1a and 1b of the laser radar device according to Embodiment 1 shown in Fig. 1 are replaced by CW laser light sources 13a and 13b. The other components are the same as those of Embodiment 1 and are designated by the same reference character strings, and only a different portion will be explained hereafter.

The CW laser light source 13a can vary its oscillating frequency within a range from f1 to f1', and oscillates a CW laser light having a set specific frequency. The CW laser light oscillated by this CW laser light source 13a is coupled to an optical fiber, and is outputted to an optical branching coupler 2a.

The CW laser light source 13b can vary its oscillating frequency within a range from f2 to f2', and oscillates a CW laser light having a set specific frequency. The CW laser light oscillated by this CW laser light source 13b is coupled to an optical fiber, and is outputted to an optical branching coupler 2b.

The frequencies f1 to f1' and f2 to f2' of the CW laser lights oscillated by the CW laser light sources 13a and 13b differ from each other and fall within the gain band of an optical fiber amplifier 6. Further, the difference between the frequencies is set in such a way as to become larger than the gain bandwidth of stimulated Brillouin scattering occurring in the optical fiber.

Further, it is preferable that the spectral width of each CW laser light is as narrow as possible in order to improve the accuracy of coherent detection. For example, it is preferable to use CW laser lights each having a spectral width of 100 kHz or less. As the CW laser light sources 13a and 13b having this feature, for example, DFB fiber lasers, DFB-LDs or the likes can be used. By, for example, performing temperature modulation on these laser light sources, the oscillating frequencies can be varied.

Further, in a case in which the oscillating frequency of the CW laser light source 13a is set to f1 and the oscillating frequency of the CW laser light source 13b is set to f2 in the configuration of Fig. 2, the configuration becomes the same as that of Fig. 1 and the same advantages as those provided by Embodiment 1 are provided.

When varying the oscillating frequency of the CW laser light source 13a from f1 to f1' in the configuration of Fig. 2, the frequency of a transmission light based on the CW laser light source 13a becomes f1'+fM1 and is different from the frequency f1+fM1 in the configuration of Fig. 1. Therefore, the angle of diffraction by a diffraction grating 9 differs and the diffracted light is emitted toward a direction of a transmission light 102a. As a result, a wind speed distribution in a sight line direction different from that in the case in which the oscillating frequency of the CW laser light source 13a is f1 (in a direction toward which the transmission light 102a is emitted) can be measured.

When varying the oscillating frequency of the CW laser light source 13b from f2 to f2' in the same way as above, the frequency of a transmission light based on the CW laser light source 13b becomes f2'+fM2 and is different from the frequency f2+fM2 in the configuration of Fig. 1. Therefore, the angle of diffraction by the diffraction grating 9 differs and the diffracted light is emitted toward a direction of a transmission light 102b. As a result, a wind speed distribution in a sight line direction different from that in the case in which the oscillating frequency of the CW laser light source 13b is f2 (in a direction toward which the transmission light 102b is emitted) can be measured.

As mentioned above, because the laser radar device according to this Embodiment 2 is configured in such a way as to vary the oscillating frequencies of the CW laser light sources 13a and 13b, the laser radar device can vary the angle of diffraction by the diffraction grating 9, and can vary the emission direction of each laser light and hence vary the sight line directions on which measurements are performed, in addition to the advantages provided by Embodiment 1.

Further, because the angle of diffraction by the diffraction grating 9 depends on the frequency of each laser light incident thereupon, by appropriately setting the oscillating frequencies of the CW laser light sources 13a and 13b, the laser lights can be transmitted toward desired directions. By doing in this way, while measurements are performed simultaneously on two different sight line directions, the sight line directions can be varied in the configuration of Fig. 2.

Further, by varying the oscillating frequencies of the CW laser light sources 13a and 13b continuously or step by step, the emission directions of the laser lights can be varied continuously or step by step, and the sight line directions on which measurements are performed can be varied continuously or step by step. As a result, the laser lights can be scanned.

In this configuration, the laser lights can be scanned with the simple configuration, and downsizing and a cost reduction of the device can be achieved. In addition, because no mechanical driving system is needed, the life of the device can be extended and the reliability of the device can be improved.

Further, because the CW laser light sources 13a and 13b oscillates CW laser lights, respectively, measurements can be performed simultaneously on two different sight line directions and the same advantages as those provided by Embodiment 1 are provided.

Further, although the two CW laser light sources 13a and 13b are used in the configuration of Fig. 2, a larger number of CW laser light sources 13 can be used. In this case, it is possible to scan laser lights in a wider range according to the number of CW laser light sources 13.

### Embodiment 3.

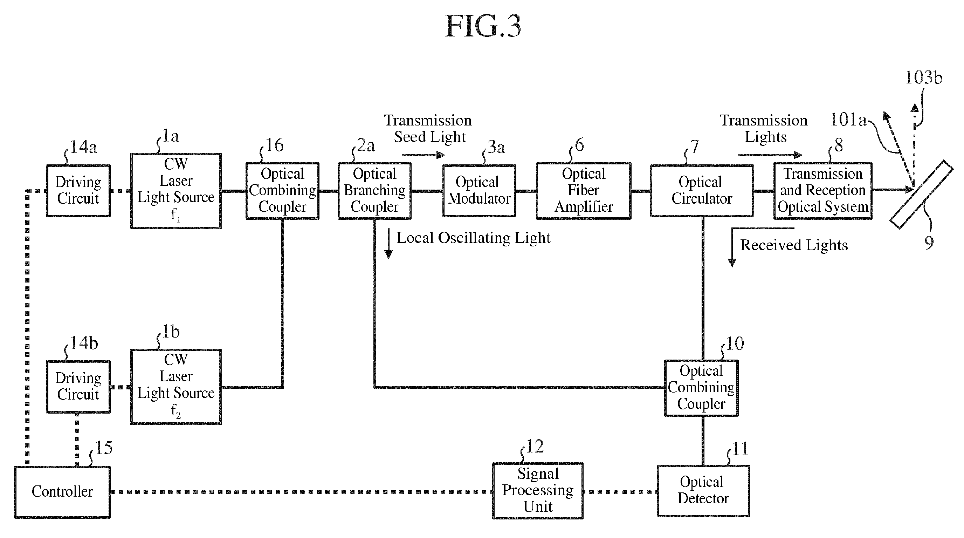

Fig. 3 is a diagram showing the configuration of a laser radar device according to Embodiment 3 of the present invention. The laser radar device according to Embodiment 3 shown in Fig. 3 is a one in which the optical branching coupler 2b, the optical modulator 3b and the optical combining couplers 4 and 5 are removed from the laser radar device according to Embodiment 1 shown in Fig. 1, and driving circuits 14a and 14b, a controller 15 and an optical combining coupler 16 are added. The other components are the same as those of Embodiment 1 and are designated by the same reference character strings, and only a different portion will be explained hereafter.

The driving circuit 14a is disposed while being brought into correspondence with a CW laser light source 1a,and operates the CW laser light source 1a.

The driving circuit 14b is disposed while being brought into correspondence with a CW laser light source 1b, and operates the CW laser light source 1b.

The controller 15 operates one of the driving circuits 14a and 14b on the basis of a processed result acquired by a signal processing unit 12 (the operating states of the CW laser light sources 1a and 1b), thereby alternately switching between the CW laser light sources 1a and 1b to operate one of these CW laser light sources.

The optical combining coupler 16 joins a path through which a CW laser light from the CW laser light source 1a passes and a path through which a CW laser light from the CW laser light source 1b passes.

An optical branching coupler 2a braches the CW laser light from the optical combining coupler 16 into two CW laser lights, and outputs one CW laser light, as a transmission seed light, to an optical modulator 3a and outputs the other CW laser light, as a local oscillating light for coherent detection, to an optical combining coupler 10.

When the CW laser light source 1a is operating in the configuration of Fig. 3, the laser light outputted from the CW laser light source 1a passes through the optical combining coupler 16. After passing through the optical combining coupler 16, the laser light is then emitted toward a direction of a transmission light 101a through the same process as that of Embodiment 1. At that time, a received light corresponds to the sight line direction of the transmission light 101a, and the signal processing unit 12 can determine the wind speed in the sight line direction of the transmission light 101a.

Further, when the CW laser light source 1b is operating in the configuration of Fig. 3, the laser light outputted from the CW laser light source 1b passes through the optical combining coupler 16. After passing through the optical combining coupler 16, the laser light then undergoes the same process as that which the laser light from the CW laser light source 1a undergoes, but the frequency of the laser light after passing through the optical modulator 3a is f2+fM1 and is therefore emitted toward a direction of a transmission light 103b. At that time, a received light corresponds to the sight line direction of the transmission light 103b, and the signal processing unit 12 can determine the wind speed in the sight line direction of the transmission light 103b.

As mentioned above, because the laser radar device according to this Embodiment 3 is configured in such a way as to alternately switch between the CW laser light source 1a and the CW laser light source 1b to operate one of them, the laser radar device can vary the sight line direction between two directions and perform measurements on the two directions.

In this configuration, Doppler shifts about the two different sight line directions cannot be measured at completely the same time. However, by shortening the time required to switch between the CW laser light sources 1a and 1b to operate one of them, measurements on the two sight line directions can be performed while the time difference is reduced. By performing a process such as an arithmetic operation, the laser radar device can also calculate two-dimensional distributions of wind directions and wind speeds which are close to real-time two-dimensional distributions.

Further, in this configuration, a local calling light inputted to an optical detector 11 is only a component based on one of the CW laser light sources 1a and 1b which generates the transmission light. Therefore, a noise component in the optical detector 11 can be reduced, and the optical detector 11 can perform detection with high sensitivity and with a high degree of accuracy.

Further, because only a received signal corresponding to one of the CW laser light sources 1a and 1b which is made to operate is detected, only one optical modulator 3a is disposed and the device can be simplified. In addition, because the restriction which is imposed on the intermediate frequency in the optical modulator 3a in order to discriminate a needed received signal from other signals in the case of Fig. 1 is eliminated, the selection of the components is facilitated.

### Embodiment 4.

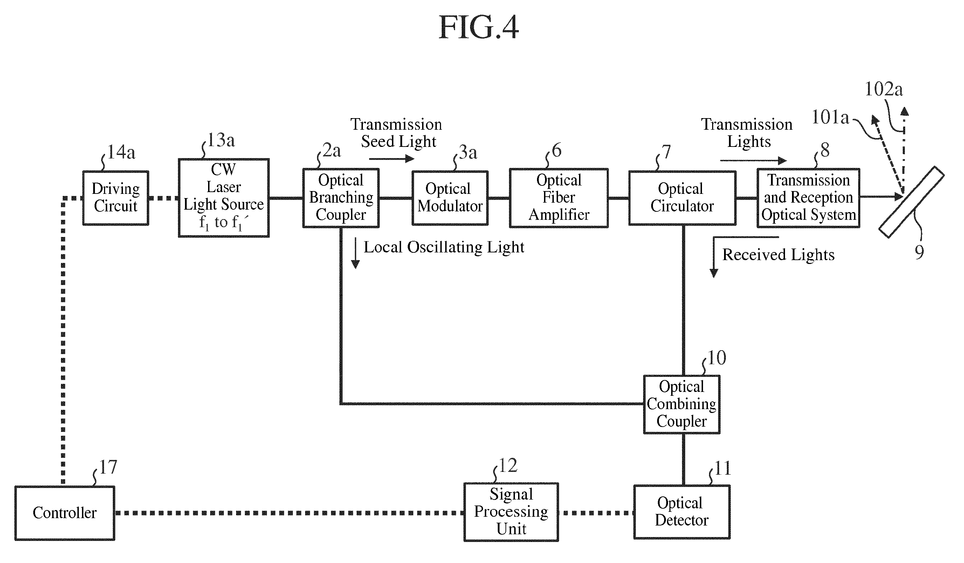

Fig. 4 is a diagram showing the configuration of a laser radar device according to Embodiment 4 of the present invention. The laser radar device according to Embodiment 4 shown in Fig. 4 is a one in which the CW laser light source 13b, the optical branching coupler 2b, the optical modulator 3b and the optical combining couplers 4 and 5 are removed from the laser radar device according to Embodiment 2 shown in Fig. 2, and a driving circuit 14a and a controller 17 are added. The other components are the same as those of Embodiment 2 and are designated by the same reference character strings, and only a different portion will be explained hereafter.

The driving circuit 14a is disposed while being brought into correspondence with a CW laser light source 13a, and operates the CW laser light source 13a.

The controller 17 operates the driving circuit 14a on the basis of a processed result acquired by a signal processing unit 12 (the operating state of the CW laser light source 13a), thereby varying the oscillating frequency of the CW laser light source 13a which operates.

An optical branching coupler 2a braches a CW laser light from the CW laser light source 13 into two CW laser lights, and outputs one CW laser light, as a transmission seed light, to an optical modulator 3a and outputs the other CW laser light, as a local oscillating light for coherent detection, to an optical combining coupler 10.

Further, the optical combining coupler 10 according to Embodiment 4 corresponds to "a fourth optical combiner that combines a scattered light received by the above-mentioned transmission and reception optical system and another laser light after being branched by the above-mentioned optical brancher, and outputs a fourth composite light" according to the present invention.

Although an instantaneous measurement can be performed on only one sight line direction in this configuration, the emission direction of the laser light can be varied within a range from that of a transmission light 101a to that of a transmission light 102a to scan the laser light by varying the oscillating frequency of the CW laser light source 13a. As a result, by performing a process such as an arithmetic operation, the laser radar device can also calculate two-dimensional distributions of wind directions and wind speeds.

Further, in this configuration, a local calling light inputted to an optical detector 11 is only a component based on the CW laser light source 13a which generates the transmission light. Therefore, a noise component in the optical detector 11 can be reduced, and the optical detector 11 can perform detection with high sensitivity and with a high degree of accuracy.

Further, because only a received signal corresponding to the CW laser light source 13a which is made to operate is detected, only one optical modulator 3a is disposed and the device can be simplified. In addition, because the restriction which is imposed on the intermediate frequency in the optical modulator 3a in order to discriminate a needed received signal from other signals in the case of Fig. 1 is eliminated, the selection of the components is facilitated.

In Embodiment 3 the case in which the laser radar device performs switching of the operations of the plurality of CW laser light sources 1a and 1b is shown, while in Embodiment 4 the case in which the laser radar device performs frequency control on the single CW laser light source 13a is shown. In contrast with this, the laser radar device can be alternatively configured in such a way that a plurality of CW laser light sources 13a and 13b are disposed, and the laser radar device performs switching of the operations of the plurality of CW laser light sources 13a and 13b and frequency control on the plurality of CW laser light sources.

### Embodiment 5.

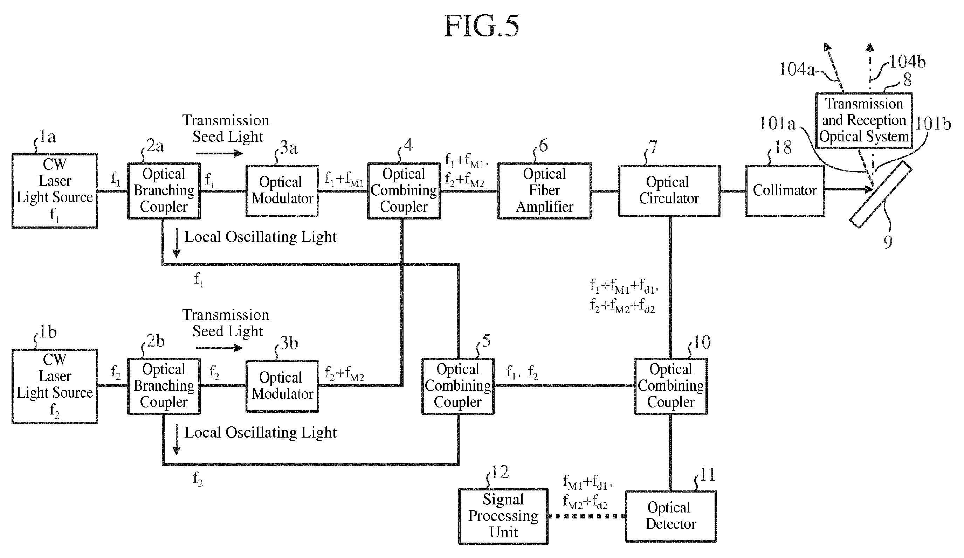

Fig. 5 is a diagram showing the configuration of a laser radar device according to Embodiment 5 of the present invention. The laser radar device according to Embodiment 5 shown in Fig. 5 is a one in which the position of the transmission and reception optical system 8 of the laser radar device according to Embodiment 1 shown in Fig. 1 is changed to a position following a diffraction grating 9, and a collimator 18 is added. The other components are the same as those of Embodiment 1 and are designated by the same reference character strings, and only a different portion will be explained hereafter.

The collimator 18 forms transmission lights which have passed through an optical circulator 7 into approximately collimated lights.

The transmission lights which are formed into the approximately collimated lights by this collimator 18 are incident upon the diffraction grating 9. After that, diffracted lights which are generated by the diffraction grating 9 are separated according to the frequencies of the transmission lights, and propagate toward directions of transmission lights 101a and 101b and are incident upon a transmission and reception optical system 8. After passing through the transmission and reception optical system 8, the diffracted lights are then emitted toward directions of transmission lights 104a and 104b, respectively.

The emission directions of the transmission lights 104a and 104b after passing through the transmission and reception optical system 8 are determined by the scale factor of the transmission and reception optical system 8 and the angles of incidence of the laser lights. Therefore, when these values are known, the emission directions of the transmission lights 104a and 104b can be known. As a result, two different sight line directions can be measured simultaneously, like in the case of Embodiment 1.

In this configuration, because by reducing the beam diameters at the time of forming the transmission lights into approximately collimated lights by using the collimator 18, the diffraction grating 9 can be downsized, the manufacture of the diffraction grating 9 is facilitated and the selection of the components is facilitated, a cost reduction of the device can be achieved. Further, the device can be downsized.

The transmission and reception optical system 8 enables the transmission lights 101a and 101b to be incident upon incidence openings. Further, in order to perform measurements on desired sight line directions, the angle of diffraction provided by the diffraction grating 9 is designed to a suitable value in consideration of the scale factor of the transmission and reception optical system 8.

Further, the configuration in which the diffracted lights generated by the diffraction grating 9 are made to pass through the transmission and reception optical system 8 can be applied to all of the above-mentioned embodiments.

### Embodiment 6.

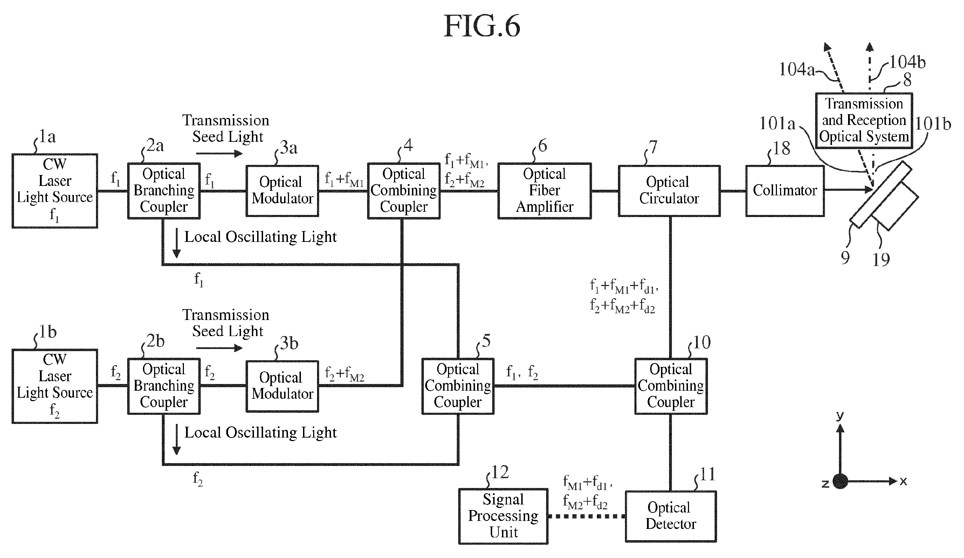

Fig. 6 is a diagram showing the configuration of a laser radar device according to Embodiment 6 of the present invention. The laser radar device according to Embodiment 6 shown in Fig. 6 is a one in which a driving unit 19 is added to the laser radar device according to Embodiment 5 shown in Fig. 5. The other components are the same as those of Embodiment 5 and are designated by the same reference character strings, and only a different portion will be explained hereafter.

In the configuration of Fig. 6, the driving unit 19 is disposed on a diffraction grating 9. In a case in which no driving unit 19 is disposed, transmission lights 104a and 104b are emitted into an x-y plane when the plane is expressed by using a coordinate system written in the drawing.

The driving unit 19 varies the installation angle of the diffraction grating 9, and can vary the installation angle of the diffraction grating 9 in such a way that the plane of incidence of the diffraction grating 9 has an inclination with respect to the z axis. As a result, each of the transmission lights 104a and 104b is emitted with an inclination with respect to the x-y plane. By varying the inclination of the plane of incidence of the diffraction grating 9 with respect to the z axis in this way, the transmission lights can be scanned in a direction of the z axis. Therefore, the emission direction of each of the laser lights can be extended to a two-dimensional direction, and three-dimensional distributions of wind directions and wind speeds can be measured. As the driving unit 19, a movable stage or the like using a motor, a piezo-electric element or the like can be used.

Further, the driving unit 19 can be configured in such a way as to rotate the diffraction grating 9 about the z axis. By rotating the diffraction grating 9 by using the driving unit 19, the angle of incidence of each laser light with respect to the diffraction grating 9 can be varied, and each transmission light can be scanned also in the x-y plane and the measurable range of sight line directions can be extended.

The configuration in which the driving unit 19 is disposed on the diffraction grating 9 can be applied to all of the above-mentioned embodiments.

Although an optical fiber amplifier 6 is used in above-mentioned Embodiments 1 to 6, when the light power of each transmission light which is needed for desired device performance can be acquired only from the outputs of the CW laser light sources 1 or 13, the optical fiber amplifier 6 is not needed.

In the case in which the optical fiber amplifier 6 is used, the light power of each laser light to be transmitted can be further increased, the intensity of the received light can be increased, the accuracy of measurements can be improved and the measurable distance can be increased.

Further, in a case of further amplifying each laser light amplified by the optical fiber amplifier 6, a space-type laser light amplifier can be used. Because it is hard for a nonlinear phenomenon to occur in the space-type laser light amplifier, the peak power of the outputted light can be increased as compared with the case of using the optical fiber amplifier 6.

However, in the case of using the space-type laser light amplifier, a space-type transmission and reception light separating device is needed. By increasing the light power of each laser light to be transmitted by using the amplifier in this way, the intensity of the received light can be increased, the accuracy of measurements can be improved and the measurable distance can be increased.

### Embodiment 7.

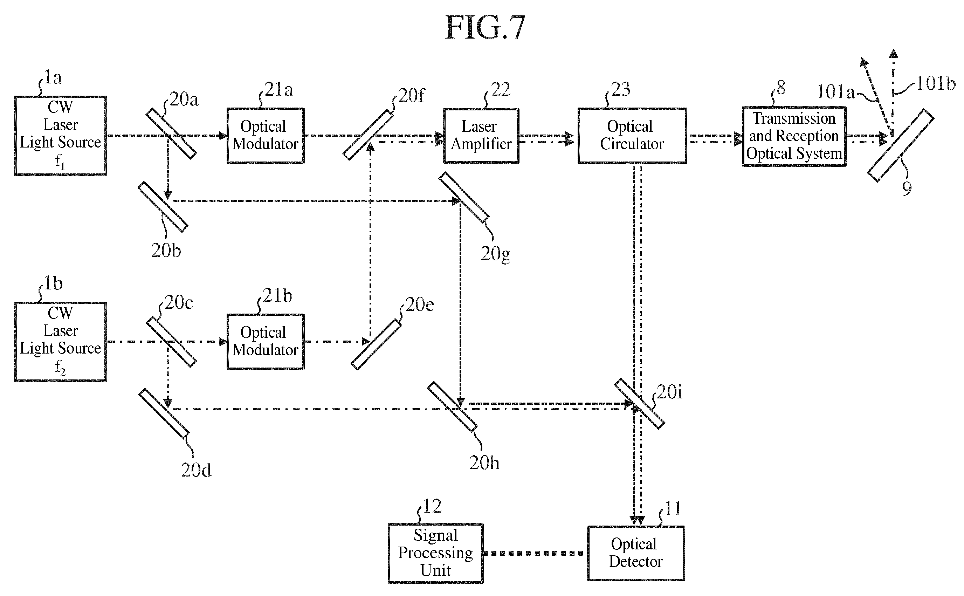

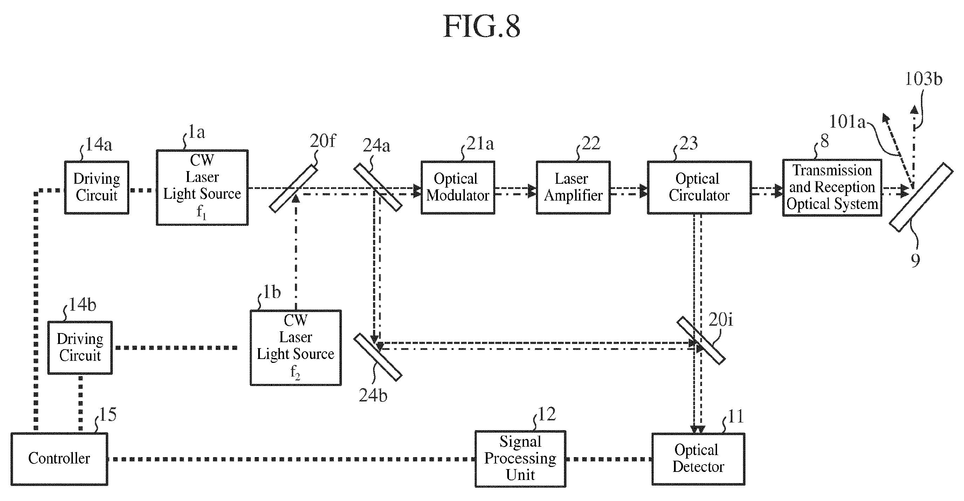

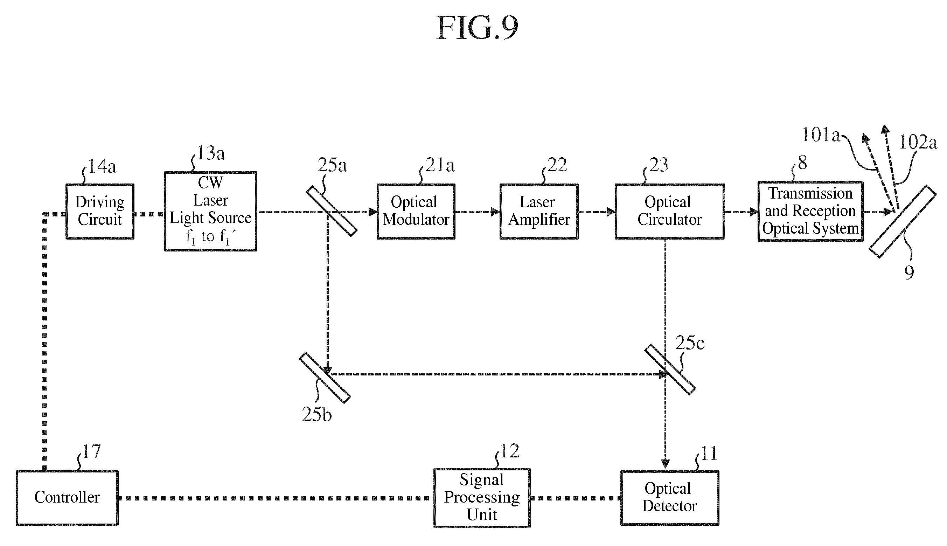

Although the light propagation path of each laser light within the device is configured using an optical fiber part in Embodiments 1 to 6, there can be provided a configuration in which each laser light is made to propagate in space by using space-type optical components, as shown in Figs. 7 to 9.

In this case, the optical couplers can be replaced by optical elements such as mirrors that reflect laser lights. For example, in a case in which the configuration shown in Fig. 1 is modified to a space propagation type configuration, as shown in Fig. 7, partially reflecting mirrors, beam splitters or the likes (in the configuration of Fig. 7, mirrors 20a to 20d) can be used as the optical branching couplers 2a and 2b, and partially reflecting mirrors, beam splitters, band pass or reflecting mirrors or the likes (in the configuration of Fig. 7, mirrors 20e to 20i) can be used as the optical combining couplers 4, 5 and 10. Each of these optical elements is used while the wavelength band region of light to be reflected and its reflectivity are selected appropriately according to the branching ratio and the wavelength of the laser light. Further, the optical modulators 3a and 3b, the optical fiber amplifier 6 and the optical circulator 7 are replaced by space-type elements (optical modulators 21a and 21b, a laser amplifier 22 and an optical circulator 23), respectively. Further, the optical path of each laser light can be modified as appropriate by using reflecting mirrors or the likes. In addition, in a case in which control of polarization is needed, polarization can be controlled by using a wavelength plate.

As mentioned above, because the laser radar device according to this Embodiment 7 is configured in such a way as to cause laser lights to propagate in space, the components can be downsized and installed in a high density by using optical space-type elements, and hence the device can be downsized. Further, in the space propagation type configuration, the occurrence of a nonlinear effect like above-mentioned stimulated Brillouin scattering can be suppressed, and the peak power of each transmission light can be increased without imposing any restriction due to such a nonlinear effect on the laser amplifier 22.

In the examples of Figs. 7 to 9, optical fiber parts can be used as a part of the device. Because alignment adjustment becomes unnecessary particularly in a case of using optical fiber couplers for mirrors that perform branching of a laser light and combining of laser lights, the device can be configured easily. Further, by, for example, modifying only the laser amplifier 22 to a space type one, the peak power of each transmission light can be increased and the light power of each transmission light can also be increased without receiving any restriction due to a nonlinear effect.

Further, the configuration of using optical space-type elements as shown in Figs. 7 to 9 can be applied also to the configuration shown in Embodiment 6 in which the driving unit 19 is disposed on the diffraction grating 9.

Further, although the case in which the laser radar device according to any one of above-mentioned Embodiments 1 to 7 detects an aerosol as a target is shown above, the present invention is not limited to this example, and the present invention can be applied similarly to a case in which the laser radar device performs detection on, for example, the air, a flying object, a building or the like as a target.

1

### Embodiment 8.

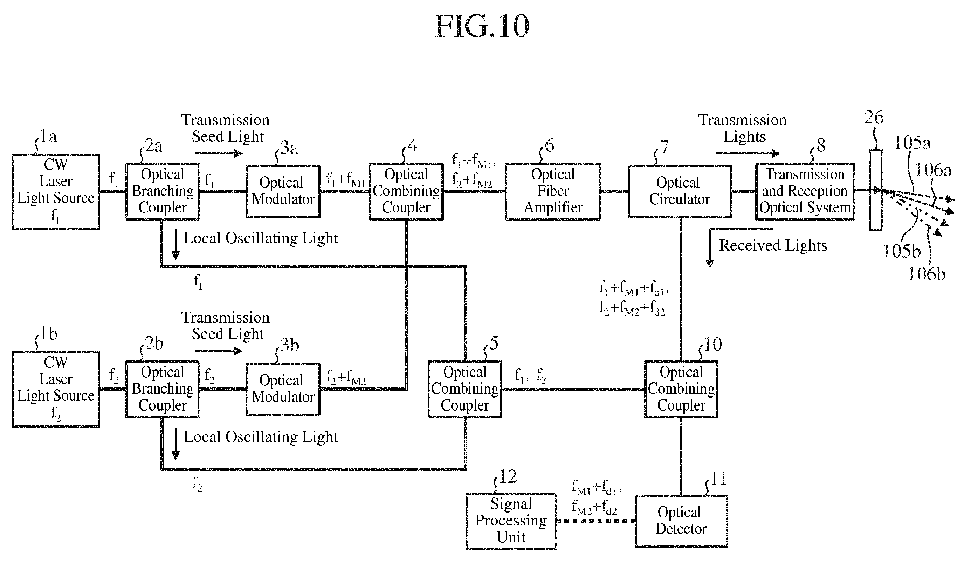

Fig. 10 is a diagram showing the configuration of a laser radar device according to Embodiment 8 of the present invention. The laser radar device according to Embodiment 8 shown in Fig. 10 is a one in which the diffraction grating 9 of the laser radar device according to Embodiment 1 shown in Fig. 1 is replaced by a diffraction grating (a dispersing element) 26. The other components are the same as those of Embodiment 1 and are designated by the same reference character strings, and only a different portion will be explained hereafter.

The diffraction grating 26 is a transmission type diffraction grating that employs a birefringent material. The optical axis of this diffraction grating 26 is oriented toward a predetermined direction in such a way that birefringence occurs in a transmission light incident thereupon. As the birefringent material, not only a uniaxial birefringent crystal, such as crystal (SiO2), sapphire (Al2O3) or calcite (CaCO3), but also a biaxial crystal, such as KYW, LBO or KTP, can be used. Further, in the case of employing a birefringent crystal, the refractive index difference between an ordinary ray and an extraordinary ray can be maximized when the crystal is placed in such a way that its optical axis is perpendicular to the axis of a laser light incident upon the crystal.

The laser light incident upon the birefringent material propagates while being separated into an ordinary ray and an extraordinary ray according to the state of polarization. Further, the refractive index to the ordinary ray and that to the extraordinary ray differ from each other.

Therefore, a transmission light based on a CW laser light source 1a which is incident upon the diffraction grating 26 and a transmission light based on a CW laser light source 1b which is incident upon the diffraction grating propagate while being separated into ordinary rays and extraordinary rays, respectively.

Each transmission light which has propagated the diffraction grating 26 is refracted by the interface between the diffraction grating 26 and the air, and is emitted into the air. Because the refractive indexes of the ordinary ray and the extraordinary ray differ from each other, the ordinary ray and the extraordinary ray are emitted at different angles of refraction, respectively.

Further, because the transmission light based on the CW laser light source 1a and the transmission light based on the CW laser light source 1b have different frequencies, the transmission lights are emitted at different angles of diffraction, respectively.

As a result, the transmission lights are emitted toward four different directions, as denoted by transmission lights 105a, 105b, 106a and 106b shown in Fig. 10, and the laser radar device shown in Fig. 10 becomes possible to measure wind speeds with respect to the four different sight line directions.

In Fig. 10, the transmission light 105a denotes the transmission light corresponding to the ordinary ray included in the transmission light based on the CW laser light source 1a. Further, the transmission light 106a denotes the transmission light corresponding to the extraordinary ray included in the transmission light based on the CW laser light source 1a. Further, the transmission light 105b denotes the transmission light corresponding to the ordinary ray included in the transmission light based on the CW laser light source 1b.Further, the transmission light 106b denotes the transmission light corresponding to the extraordinary ray included in the transmission light based on the CW laser light source 1b.

Further, although the ordinary ray and the extraordinary ray are emitted into a plane parallel to the page in the configuration of Fig. 10, the ordinary ray and the extraordinary ray can be alternatively emitted while having angles in a plane perpendicular to the page. In this case, the emission direction of each laser light can be extended to a two-dimensional direction, and three-dimensional distributions of wind directions and wind speeds can be measured.

Further, in the configuration of Fig. 10, the polarization directions of the transmission lights can be changed in a switching manner in such a way that either or both of the polarization directions of the transmission lights based on the CW laser light sources 1a and 1b are parallel or perpendicular to a plane which is formed by the optical axis of the birefringent material and the incident light axes of the transmission lights by using a polarization controller not shown. In this case, because a selection between the ordinary ray and extraordinary ray which are generated in the birefringent material can be made and hence the angle of emergence of each transmission light can be selected, each transmission light can be emitted only toward a desired direction and an observation can be performed on the direction.

The switching of the polarization direction of each transmission light by using the polarization controller can be controlled by directly controlling the output polarization states of the CW laser light sources 1a and 1b or by using a polarization element such as a wavelength plate or a polarization controller.

Further, in the configuration of Fig. 10, the polarization directions of each received light and the corresponding local oscillating light can be matched to each other by using a polarization controller not shown. By matching the polarization direction of this received light to that of the local oscillating light, optical heterodyne detection can be performed efficiently.

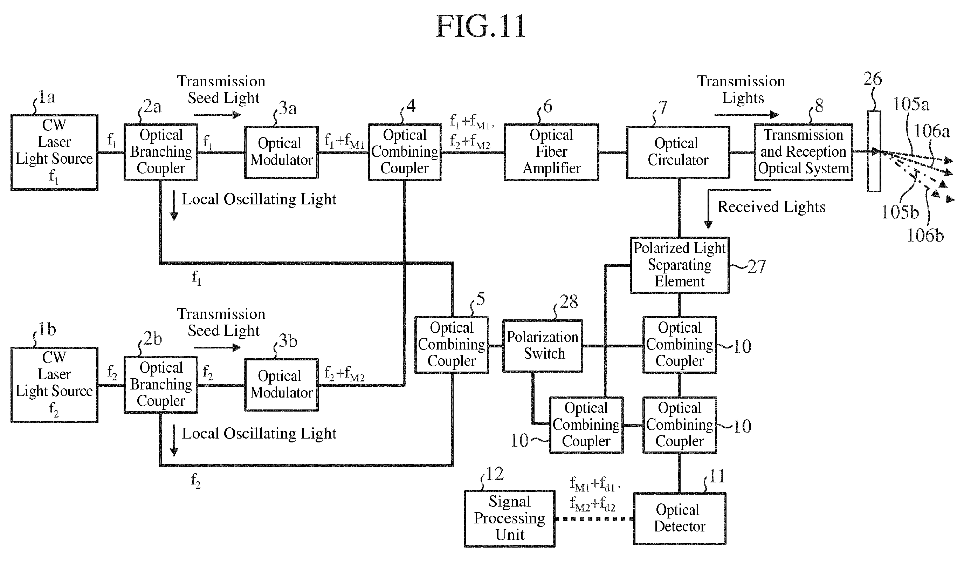

Further, as shown in Fig. 11, the received lights can be separated according to their polarization directions by using a polarized light separating element (a polarization separator) 27, switching between output paths for each local oscillating light according to its polarization direction can be performed to output the local oscillating light by using a polarization switch (a switch) 28, and combining can be performed in such a way that the polarization directions of the received lights are matched to those of the local oscillating lights, respectively, and optical heterodyne detection can be performed.

By switching between the output paths for each local oscillating light according to its polarization direction in this way, the light power needed for the local oscillating light can be reduced, and optical heterodyne detection can be performed on only a received component having a certain polarization direction among the received lights. Therefore, observations on desired directions can be performed by using the single optical detector 11.

The configuration of using the transmission type diffraction grating 26 which employs a birefringent material can be applied to all of Embodiments 2 to 7.

In addition, while the invention has been described in its preferred embodiments, it is to be understood that an arbitrary combination of two or more of the embodiments can be made, various changes can be made in an arbitrary component according to any one of the embodiments, and an arbitrary component according to any one of the embodiments can be omitted within the scope of the invention.

### INDUSTRIAL APPLICABILITY

The laser radar device according to the present invention can simultaneously perform measurements on many sight line directions with a simple and low-cost configuration and without using a scanner device that mechanically drives a component, and is suitable for use as a laser radar device or the like that emits a laser light into the air, receives a scattered light of that laser light which is scattered by a target, and extracts information about the target from the scattered light.

### EXPLANATIONS OF REFERENCE NUMERALS

1, 1a,1b, 13, 13a, 13b CW laser light source (reference light source), 2, 2a, 2b optical branching coupler, 3, 3a, 3b, 21a, 21b optical modulator, 4 optical combining coupler (first optical combiner), 5 optical combining coupler (second optical combiner), 6 optical fiber amplifier, 7, 23 optical circulator, 8 transmission and reception optical system, 9 diffraction grating (dispersing element), 10 optical combining coupler (third or fourth optical combiner), 11 optical detector, 12 signal processing unit (information extractor), 14, 14a, 14b driving circuit, 15, 17 controller, 16 optical combining coupler, 18 collimator, 19 driving unit, 20a to 20i, 24a, 24b, 25a to 25c mirror, 22 laser amplifier, 26 diffraction grating (dispersing element), 27 polarized light separating element (polarization separator), 28 polarization switch (switch), and 101a, 101b, 102a, 102b, 103b, 104a, 104b, 105a, 105b, 106a, 106b transmission light.

## Claims

1. A laser radar device comprising:
a plurality of reference light sources to oscillate laser lights having different frequencies;
a plurality of optical branchers disposed while being respectively brought into correspondence with said reference light sources, and each to branch a laser light oscillated by a corresponding one of said reference light sources;
a plurality of optical modulators disposed while being respectively brought into correspondence with said optical branchers, and each to modulate one laser light after being branched by a corresponding one of said optical branchers;
a first optical combiner to combine laser lights modulated by said optical modulators and output a first composite light;
a second optical combiner to combine other laser lights after being branched by said optical branchers and output a second composite light;
a transmission and reception optical system to emit the first composite light outputted by said first optical combiner, and receive scattered lights of said first composite light which are scattered by a target;
a third optical combiner to combine the scattered lights received by said transmission and reception optical system and the second composite light outputted by said second optical combiner, and output a third composite light;
an optical detector to detect beat signals from the third composite light outputted by said third optical combiner;
an information extractor to extract information about said target from the beat signals detected by said optical detector; and
a dispersing element placed forward or backward with respect to said transmission and reception optical system, and to emit a light incident thereupon toward a specific direction according to an angle and a frequency of said incident light.

2. The laser radar device according to claim 1, wherein said reference light sources can vary the frequencies of the laser lights oscillated thereby.

3. The laser radar device according to claim 1, wherein said laser radar device comprises a controller that performs operation switching on said reference light sources.

4. The laser radar device according to claim 2, wherein said laser radar device comprises a controller that performs operation switching and frequency control on said reference light sources.

5. The laser radar device according to claim 1, wherein light propagation paths of the lights within the device consist of optical fibers.

6. The laser radar device according to claim 5, wherein said laser radar device comprises at least one optical fiber amplifier that is disposed on a light propagation path on a transmission side within the device, and amplifies light power of a light incident thereupon.

7. The laser radar device according to claim 6, wherein said laser radar device comprises at least one space-type optical fiber amplifier of that is disposed on the light propagation path on the transmission side within the device, and amplifies light power of a light incident thereupon.

8. The laser radar device according to claim 6, wherein a difference between the frequencies of the laser lights oscillated by said reference light sources is larger than a gain bandwidth of stimulated Brillouin scattering occurring in said optical fiber.

9. A laser radar device comprising:
a reference light source to oscillate a laser light having a specific frequency and can vary said frequency;
an optical brancher to branch the laser light oscillated by said reference light source;
an optical modulator to modulate one laser light after being branched by said optical brancher;
a transmission and reception optical system to emit the laser light modulated by said optical modulator and receive a scattered light of said laser light which is scattered by a target;
a fourth optical combiner to combine the scattered light received by the said transmission and reception optical system and another laser light after being branched by said optical brancher, and output a fourth composite light;
an optical detector to detect a beat signal from the fourth composite light outputted by said fourth optical combiner;
an information extractor to extract information about said target from the beat signal detected by said optical detector; and
a dispersing element placed forward or backward with respect to said transmission and reception optical system, and to emit a light incident thereupon toward a specific direction according to an angle and a frequency of said incident light.

10. The laser radar device according to claim 9, wherein said laser radar device comprises a controller that performs frequency control on said reference light source.

11. The laser radar device according to claim 9, wherein light propagation paths of the lights within the device consist of optical fibers.

12. The laser radar device according to claim 11, wherein said laser radar device comprises at least one optical fiber amplifier that is disposed on a light propagation path on a transmission side within the device, and amplifies light power of a light incident thereupon.

13. The laser radar device according to claim 12, wherein said laser radar device comprises at least one space-type optical fiber amplifier of that is disposed on the light propagation path on the transmission side within the device, and amplifies light power of a light incident thereupon.

14. The laser radar device according to claim 1, wherein said dispersing element is a one of reflection type or transmission type.

15. The laser radar device according to claim 9, wherein said dispersing element is a one of reflection type or transmission type.

16. The laser radar device according to claim 1, wherein said laser radar device comprises a driving mechanism that varies an installation angle of said dispersing element.

17. The laser radar device according to claim 9, wherein said laser radar device comprises a driving mechanism that varies an installation angle of said dispersing element.

18. The laser radar device according to claim 1, wherein said dispersing element is a diffraction grating of transmission type that employs a uniaxial or biaxial birefringent material.

19. The laser radar device according to claim 9, wherein said dispersing element is a diffraction grating of transmission type that employs a uniaxial or biaxial birefringent material.

20. The laser radar device according to claim 18, wherein an angle which an axis of the light incident upon said diffraction grating forms with an optical axis of a crystal is 90 degrees.

21. The laser radar device according to claim 19, wherein an angle which an axis of the light incident upon said diffraction grating forms with an optical axis of a crystal is 90 degrees.

22. The laser radar device according to claim 18, wherein said laser radar device comprises a polarization controller that controls polarization directions of the laser lights oscillated by said reference light sources.

23. The laser radar device according to claim 19, wherein said laser radar device comprises a polarization controller that controls a polarization direction of the laser light oscillated by said reference light source.

24. The laser radar device according to claim 18, wherein said laser radar device comprises a polarization controller that matches polarization directions of the scattered lights received by said transmission and reception optical system to that of the second composite light outputted by said second optical combiner.

25. The laser radar device according to claim 19, wherein said laser radar device comprises a polarization controller that matches a polarization direction of the scattered light received by said transmission and reception optical system to that of the other laser light after being branched by said optical brancher.

26. The laser radar device according to claim 18, wherein said laser radar device comprises a polarization separator that separates the scattered lights received by said transmission and reception optical system according to their polarization directions, and a switch that outputs, in a switching manner, each light which is included in the second composite light outputted by said second optical combiner and which has a polarization direction matching that of one scattered light after being separated by said polarization separator, and wherein said third optical combiner combines the scattered lights after being separated by said polarization separator and the second composite light outputted in a switching manner by said switch.

27. The laser radar device according to claim 19, wherein said laser radar device comprises a polarization separator that separates scattered lights received by said transmission and reception optical system according to their polarization directions, and a switch that outputs, in a switching manner, each light which is included in the other laser light after being branched by said optical brancher and which has a polarization direction matching that of one scattered light after being separated by said polarization separator, and wherein said fourth optical combiner combines the scattered lights after being separated by said polarization separator and the laser lights outputted in a switching manner by said switch.
